(19) Europäisches Patentamt
European Patent Office
Office européen des brevets

(11) Publication number: 0 323 887 A2

(12) # EUROPEAN PATENT APPLICATION

(21) Application number: 89300015.8

(22) Date of filing: 04.01.89

(51) Int. Cl.4: G 03 C 1/52
G 03 F 7/00

(30) Priority: 06.01.88 JP 1065/88

(43) Date of publication of application:
12.07.89 Bulletin 89/28

(84) Designated Contracting States: DE GB

(71) Applicant: FUJI PHOTO FILM CO., LTD.
210 Nakanuma Minami Ashigara-shi
Kanagawa 250-01 (JP)

(72) Inventor: Ichikawa, Kimio
c/o Fuji Photo Film Co., Ltd. 200, Onakazato
Fujinomiya-shi Shizuoka (JP)

Shimada, Hirokazu
c/o Fuji Photo Film Co., Ltd. 200, Onakazato
Fujinomiya-shi Shizuoka (JP)

Ikeda, Kensuke
c/o Fuji Photo Film Co., Ltd. 200, Onakazato
Fujinomiya-shi Shizuoka (JP)

(74) Representative: Diamond, Bryan Clive et al
Gee & Co. Chancery House Chancery Lane
London WC2A 1QU (GB)

(54) **Heat-sensitive diazo recording materials.**

(57) A support, preferably of paper, is coated with (a) a heat-sensitive layer containing (i) an aromatic, preferably aryl, diazonium salt, (ii) a compound which couples with the salt to form a dye, and preferably (iii) a basic nitrogenous compound, at least one of the salt and coupler being in an oily solvent and enclosed in microcapsules, e.g. of polyurethane or polyurea, the wall of which becomes permeable when heated; the layer being optionally coated as two sublayers of differing components; and (b) a protective layer containing in a binder an alginate, e.g. an alkali metal, ammonium or organic amine salt of alginic acid, preferably Na alginate, in an amount of 0.03 to 0.4 g/m$^2$, and optionally a pigment. Local heating, e.g. by a thermal head, gives a good color image. The material has good storage life prior to use without fogging.

EP 0 323 887 A2

**Description**

## HEAT-SENSITIVE DIAZO RECORDING MATERIALS

This invention relates to heat-sensitive recording materials and in particular to fixable diazo-based heat-sensitive recording materials. More specifically, this invention concerns heat-sensitive, light fixable recording materials having excellent storage properties before heat recording and, moreover, a high color density during heat recording.

Leuco dye-type materials are usually used as heat-sensitive recording materials. However, these heat-sensitive recording materials have the defect that they form colors in undesired areas and the recorded image is stained as a result of severe handling or heating or due to the adhesion of solvents after recording. In recent years, extensive research has been conducted to identify diazo dye-type heat-sensitive recording materials which do not suffer from these problems, as disclosed, for example, in JP-A-57-123086 (the term "JP-A" as used herein means an "unpublished Japanese patent application") and in J. Soc. Image Electronics (Japanese) 57-11290. In one such method, heat recording is carried out on a recording material employing diazo compounds, coupling components and basic components (including substances which become basic as a result of heat). Color formation is then stopped by light irradiation to decompose the unreacted diazo compounds. According to this method, color formation can be stopped (fixed) in the parts of the recording material where recording is not required. However, even in this type of recording material, precoupling gradually progresses during storage to result in undesirable coloring (fogging). Precoupling can be prevented by having at least one of the color forming components present in the form of discontinuous grains. However, the fresh storage properties (prior to heat recording) of such recording materials are unsatisfactory and the thermal color forming properties are reduced. Precoupling can also be prevented by separating the diazo compounds and the coupling components into different layers in order to minimize the contact between the components as disclosed, for example, in JP-A-57-123086. Although the fresh storage properties are thus improved, this method is impracticable because the resulting reduction in thermal color forming properties is too great to allow the recording material to respond to high-speed recording. Methods for improving both fresh storage properties and thermal color forming properties include segregation of either the coupling component or the basic substance from the other color forming components by encapsulation with a non-polar wax-like substance, as disclosed in JP-A-57-44141 and JP-A-57-142636 or with a hydrophobic macromolecular substance as disclosed in JP-A-57-192944. However, these encapsulation methods involve dissolving waxes or macromolecular substances and then dissolving or dispersing therein the coupling components in solutions thereof, thus forming a capsule different to that having a shell and core structure. Precoupling takes place in the wall interface of the capsule during storage since the color forming components do not become a core material for the capsule but are mixed uniformly with the encapsulation substance. The net result is that adequate fresh storage properties can not be obtained by dissolving the color forming components into the encapsulation material. In addition, if the capsule wall is not thermally fused during dispersion and encapsulation of the color forming components, the thermal color forming properties are reduced as the color forming reaction is impaired. Moreover, these encapsulation methods require the additional production step of removing the solvent used to dissolve the wax or macromolecular substance.

In order to overcome the above problems, it has been discovered that excellent heat-sensitive recording materials are obtained using a microencapsulation method in which at least one of the components involved in the color forming reaction is contained in a core material, and wherein a wall is formed around this core material by polymerization.

Even with heat-sensitive recording materials which use these microencapsulation methods, however, further improvements are desirable since the optical density of the recorded image part may be reduced as a result of long-term storage following heat recording.

Thus, a first object of this invention is to provide heat-sensitive recording materials with excellent fresh storage properties, rapid heat responsiveness, good thermal color forming properties and with little deterioration of the recorded image density as a result of long-term storage after heat recording.

A second objective of this invention is to provide heat-sensitive recording materials which can be fixed by photodecomposition of the unreacted color forming diazo compounds after heat recording.

A third object of this invention is to provide heat-sensitive recording materials that are easy to manufacture.

As a result of extensive research, the inventors have improved image stability by applying an overcoat layer on the recording layer such that there is not less than 0.03 $g/m^2$ and not more than 0.4 $g/m^2$ of an alginate, in a heat-sensitive recording material provided with a coating of a recording layer containing microencapsulated diazo compound and coupling component on a support.

The present invention is attained by a heat-sensitive recording material comprising a support having thereon a recording layer containing a diazo compound and a coupling component and on said recording layer an overcoat layer comprising an alginate in an amount of from 0.03 $g/m^2$ to 0.4 $g/m^2$, at least one of the diazo compound and the coupling component being microencapsulated.

The alginates used in the present invention include alkali metal salts, ammonium salts and organic amine salts of alginic acid.

Specific examples of the alginates include sodium alginate, potassium alginate, ammonium salt of alginic acid and the triethanolamine salt of alginic acid. Of these, sodium alginate is preferred. In particular, sodium

alginate having a degree of polymerization of 60 to 130 is preferred.

The overcoat layer in the present invention may comprise the alginate, binder and organic or inorganic pigments. The overcoat layer may further contain waxes such as aliphatic compounds and surfactants in order to adjust the surface tension suitably to the coating method to be used.

The microcapsules in the present invention are unlike those used in conventional recording materials.

The capsules in conventional recording materials are ruptured by heat or pressure so as to instigate a color-forming reaction by bringing the reactive substances into contact. In contrast, the present material contains microcapsules wherein the reactive substances outside and in the core of the microcapsule react mainly by permeating through the microcapsule wall upon heating.

The diazo compounds used in the present invention are diazonium groups represented by the formula (A):

$ArN_2^+X^-$

wherein Ar represents an aromatic moiety, $N_2^+$ represents a diazonium group, and $X^-$ represents an acid anion. These diazo compounds form colors by reacting with a coupling component. Unreacted diazo compounds in the present invention decompose on exposure to light.

Specifically, the aromatic moiety represented by Ar of formula (A) is preferably represented by the following formula (B).

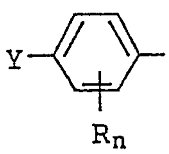

(B)

wherein Y represents a hydrogen atom, a substituted amino group, an alkoxy group, an aryloxy group, an arylthio group, an alkylthio group or an acylamino group; R represents a hydrogen atom, an alkyl group, an alkoxy group, an aryloxy group, an arylamino group or a halogen atom (e.g., I, Br, Cl, F); and n represents an integer of 1 or 2.

Preferred substituted amino groups for Y include a monoalkylamino group, a dialkylamino group, an arylamino group, a morpholino group, a piperidino group and a pyrrolidino group.

Specific examples of diazonium groups which form a salt include 4-diazo-1-dimethylaminobenzene, 4-diazo-1-diethylaminobenzene, 4-diazo-1-dipropylaminobenzene, 4-diazo-1-methylbenzylaminobenzene, 4-diazo-1-dibenzylaminobenzene, 4-diazo-1-ethylhydroxyethylaminobenzene, 4-diazo-1-diethylamino-3-methoxybenzene, 4-diazo-1-dimethylamino-2-methylbenzene, 4-diazo-1-benzoylamino-2,5-diethoxybenzene, 4-diazo-1-morpholinobenzene, 4-diazo-1-morpholino-2,5-diethoxybenzene, 4-diazo-1-morpholino-2,5-dibutoxybenzene, 4-diazo-1-anilinobenzene, 4-diazo-1-toluylmercapto-2,5-diethoxybenzene, 4-diazo-1,4-methoxybenzoylamino-2,5-diethoxybenzene and 4-diazo-1-pyrrolidino-2-ethylbenzene.

Specific examples of the acid anion represented by $X^-$ of formula (A) include $C_nF_{2n+1}COO^-$ (in which n is an integer of 3 to 9), $C_mF_{2m+1}SO_3$ (in which m is an integer of 2 to 8), $(C_\ell F_{2\ell+1}SO_2)_2CH^-$ (in which $\ell$ is an integer of 1 to 18), $B(C_6H_5)_4^-$,

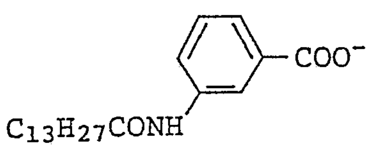

,

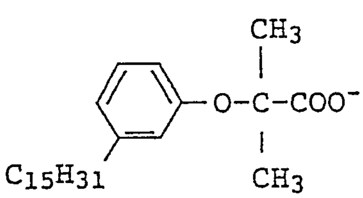

,

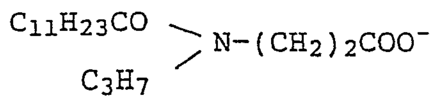 ,

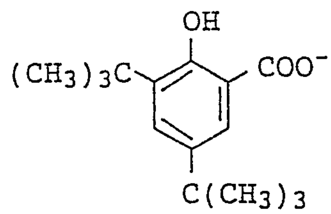 ,

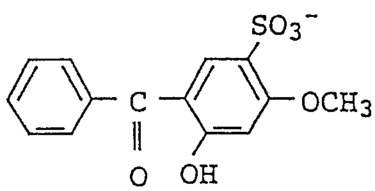 ,

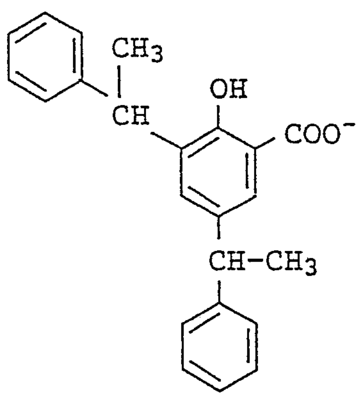 ,

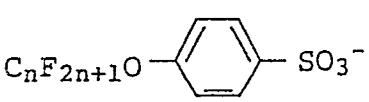 (in which n is an integer of 3 to 9),

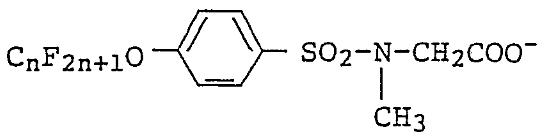

(in which n is an integer of 3 to 9),
$BF_4^-$, or $PF_6^-$.

As the acid anion, those containing a perfluoroalkyl group or a perfluoroalkenyl group, and $PF_6^-$ are particularly preferred since the use of these anions results in less fog during fresh storage.

Specific examples of the diazo compounds (diazonium salts) for use in the present invention include the following.

A-1

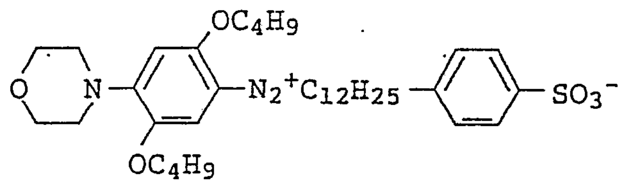

A-2

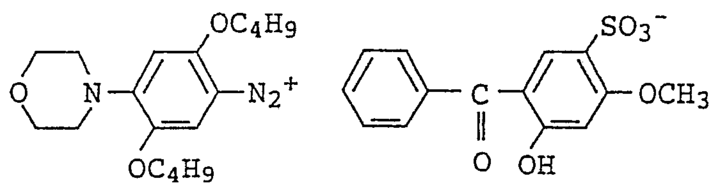

A-3

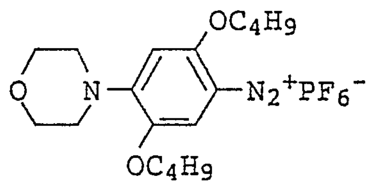

A-4

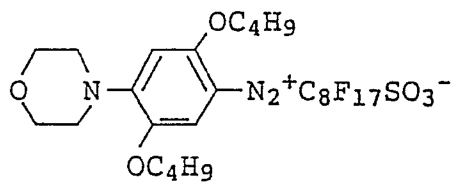

A-5

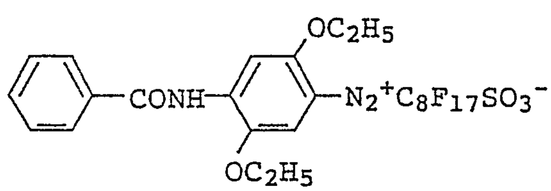

A-6

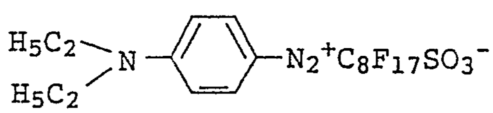

A-7

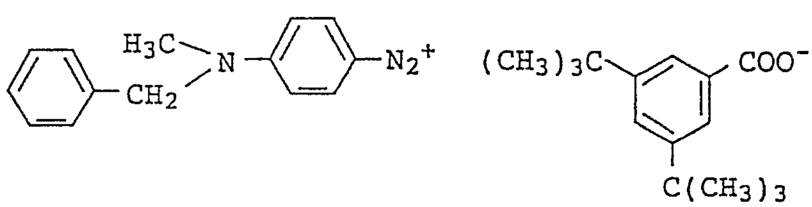

A-8

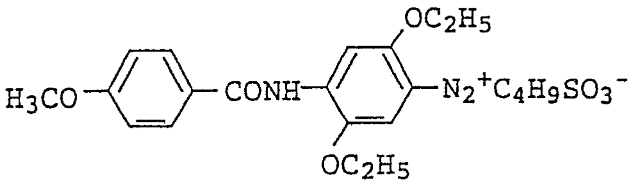

A-9

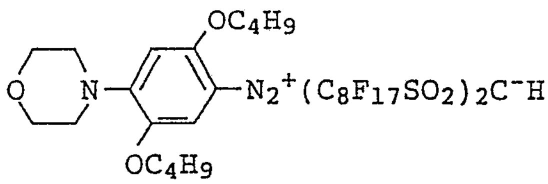

A-10

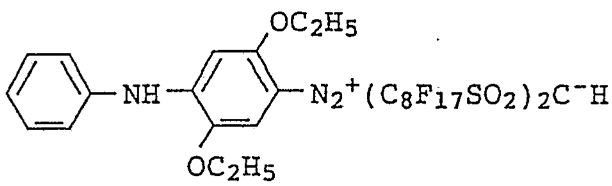

A-11

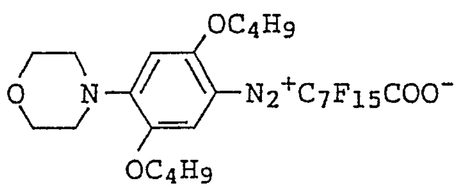

A-12

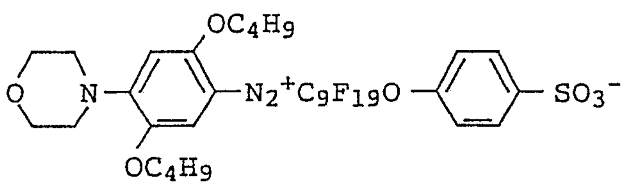

A-13

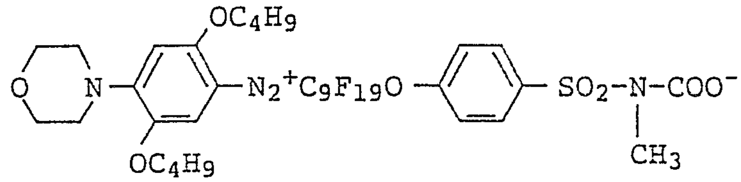

Compounds which form a dye by coupling with diazo compounds (diazonium salts) under basic conditions are the coupling components for use in the present invention and specific examples thereof include resorcinol, phloroglucinol, sodium 2,3-dihydroxynaphthalene-6-sulfonic acid, 1-hydroxy-2-naphthoic acid morpholinopropylamide, 1,5-dihydroxynaphthalene, 2,3-dihydroxynaphthalene, 2,3-dihydroxy-6-sulfanylnaphthalene, 2-hydroxy-3-naphthoic acid morpholinopropylamide, 2-hydroxy-3-naphthoic acid anilide, 2-hydroxy-3-naphthoic acid-2′-methylanilide, 2-hydroxy-3-naphthoic acid ethanolamide, 2-hydroxy-3-naphthoic acid octylamide, 2-hydroxy-3-naphthoic acid-N-dodecyl-oxypropylamide, 2-hydroxy-3-naphthoic acid tetradecylamide, acetoanilide, acetoacetoanilide, benzoylacetoanilide, 1-phenyl-3-methyl-5-pyrazolone, 1-(2′,4′,6′-trichlorophenyl)-3-benzamide-5-pyrazolone, 1-(2′,4′,6′-trichlorophenyl)-3-anilino-5-pyrazolone and 1-phenyl-3-phenylacetoamide-5-pyrazolone. Furthermore, various image tones can be obtained by the conjoint use of two or more kinds of these coupling components.

It is preferable to add basic compounds in the heat-sensitive recording materials of the present invention in order to promote color formation. Basic compounds for use in the present invention include those which are sparingly soluble in water or insoluble in water or substances which produce alkalis upon heating.

Basic compounds for use in the present invention include nitrogen-containing compounds such as inorganic and organic ammonium salts, organic amines, amides, urea and thiourea and derivatives thereof, thiazoles, pyrroles, pyrimidines, piperazines, guanidines, indoles, imidazoles, imidazolines, triazoles, morpholines, piperidines, amidines, formazines and pyridines. Specific examples of these include, for example, ammonium acetate, tricyclohexylamine, tribenzylamine, octadecylbenzylamine, stearylamine, allylurea, thiourea, methylthiourea, allylthiourea, ethylenethiourea, 2-benzylimidazole, 4-phenylimidazole, 2-phenyl-4-methylimidazole, 2-undecyl-imidazoline, 2,4,5-trifuryl-2-imidazoline, 1,2-diphenyl-4,4-dimethyl-2-imidazoline, 2-phenyl-2-imidazoline, 1,2,3-triphenylguanidine, 1,2-ditolylguanidine, 1,2-dicyclohexylguanidine, 1,2,3-tricyclohexylguanidine, guanidinetrichloro acetic acid salt, N,N′-dibenzylpiperazine, 4,4′-dithiomorpholine, morpholiniumtrichloro acetic acid salt, 2-aminobenzothiazole and 2-benzoylhydrazino-benzothiazole. Two or more of these basic compounds can be used conjointly.

To prepare the material, a reactive substance for the core material of a microcapsule is dissolved or dispersed in an organic solvent (oily liquid) which is not soluble in water. After emulsification, a microcapsule wall is formed around the core by polymerization of a polymerizable substance. The organic solvent preferably has a boiling point of not less than 180° C. Specifically, phosphoric acid esters, phthalic acid esters, carboxylic acid esters, aliphatic acid amides, alkylated biphenyls, alkylated terphenyls, chlorinated paraffin, alkylated naphthalene and diarylethane and the like can also be used. Specific examples of the organic solvent include tricresyl phosphate, trioctyl phosphate, octyldiphenyl phosphate, tricyclohexyl phosphate, dibutyl phthalate, dioctyl phthalate, dilauryl phthalate, dicyclohexyl phthalate, butyl oleate, diethyleneglycol dibenzoate, dioctyl sebacate, dibutyl sebacate, dioctyl adipate, trioctyl trimellitate, acetyltriethyl citrate, octyl maleate, dibutyl maleate, isopropyl biphenyl, isoamyl biphenyl, chlorinated paraffin, diisopropylnaphthalene, 1,1′-ditolylethane, 2,4-ditertiary aminophenol, and N,N-dibutyl-2-butoxy-5-tertiaryoctylaniline.

Of these, the ester-based solvents such as dibutyl phthalate, tricresyl phosphate, diethyl phthalate and dibutyl maleate are particularly preferred.

Regarding the microcapsules in the present invention, once the core material containing the reactive substance has been emulsified, a wall of a macromolecular substance (i.e., a microcapsule wall) is formed around the oil drops. The reactant which forms the macromolecular substance is added to the inside of the oil drop and/or the outside of the oil drop. Specific examples of the macromolecular substance include polyurethane, polyurea, polyamide, polyester, polycarbonate, urea-formaldehyde resin, melamine resin, polystyrene, styrene-methacrylate copolymers, styreneacrylate copolymers, gelatin, polyvinylpyrrolidone and polyvinyl alcohol.

Two or more kinds of macromolecular substances may be used conjointly. Preferred macromolecular substances include polyurethane, polyurea, polyamide, polyester and polycarbonate, and of these polyurethane and polyurea are particularly preferred.

The effects of the microcapsule wall in the present invention are particularly pronounced when using a microencapsulation method with polymerization of the reactant from within the oil drop. Thus, within a short time, it is possible to produce a desirable capsule for a recording material having a uniform particle size and

excellent fresh storage properties.

Specific examples of these methods and compounds are disclosed in U.S. Patents 3,726,804 and 3,796,669.

For example, a microcapsule wall of polyurethane surrounding a core material can be formed by first dispersing the core material in an oily liquid followed by addition of a polyfunctional isocyanate compound into the resulting mixture. A second substance reactive with the polyfunctional isocyanate (for example, a polyol) and water is then added to the mixture. Following emulsification and dispersion in water, a polymer-forming reaction is then initiated at the oil-drop surface by raising the temperature of the dispersion. At this time, a low-boiling-point auxiliary solvent (e.g., methylene chloride, chloroform, ethyl acetate, acetone, etc.) having powerful dissolving strength may be used in the oily liquid.

Use of the polyisocyanate and the polyol or polyamine reactants is disclosed in U.S. Patents 3,281,383, 3,773,695 and 3,793,268, JP-B-48-40347 and JP-B-49-24159 (the term "JP-B" as used herein means an "examined Japanese patent publication") and in JP-A-48-80191 and JP-A-48-84086 and these may also be used.

In addition, tin salts and the like can be used conjointly in order to accelerate the urethane-forming reaction.

In particular, the fresh storage properties are improved when a polyfunctional isocyanate is used as the first wall-forming substance and a polyol is used as the second wall-forming substance. In addition, it is also possible to vary the thermal transmission properties of the microcapsule wall by employing various combinations of reactants.

Polyfunctional isocyanates which can serve as the first wall-forming substances of the present invention include, for example, m-phenylenediisocyanate, p-phenylenediisocyanate, 2,6-tolylenediisocyanate, 2,4-tolylenediisocyanate, naphthalene-1,4-diisocyanate, diphenylmethane-4,4′-diisocyanate, 3,3′-dimethoxy-4,4′-biphenyl-diisocyanate, 3,3′-dimethyl-diphenylmethane-4,4′-diisocyanate, xylylene-1,4-diisocyanate, 4,4′-diphenylpropanediisocyanate, trimethylenediisocyanate, hexamethylenediisocyanate, propylene-1,2-diisocyanate, butylene-1,2-diisocyanate, cyclohexylene-1,2-diisocyan ate, cyclohexylene-1,4-diisocyanate and other such diisocyanates; 4,4′,4″-triphenylmethanetriisocyanate, toluene-2,4,6-triisocyanate and similar triisocyanates; 4,4′-dimethyldiphenylmethane-2,2′,5,5′-tetraisocyanate and similar tetraisocyanates; hexamethylenediisocyanate and trimethylolpropane adducts; 2,4-tolylenediisocyanate and trimethylolpropane adducts; xylylenediisocyanate and trimethylolpropane adducts; tolylenediisocyanate and hexanetriol adducts; and other similar isocyanate prepolymers.

Polyols which can serve as the second wall-film forming substance include aliphatic and aromatic polyhydric alcohols, hydroxypolyesters, hydroxypolyalkylene ethers and the like. Preferred polyols include polyhydroxy compounds having a molecular weight of 5,000 or less which have a molecular structure wherein groups (I), (II), (III) or (IV), as defined below, are positioned between two hydroxyl groups.

(I) An aliphatic hydrocarbon group having 2 to 8 carbon atoms.

(II) $-\overset{|}{\underset{|}{C}}-O-Ar-O-\overset{|}{\underset{|}{C}}$

(III) $-\overset{|}{\underset{|}{C}}-Ar-\overset{|}{\underset{|}{C}}-$

(IV) $-O-Ar-\overset{|}{\underset{|}{C}}-Ar-O-\overset{|}{\underset{|}{C}}$

Here, Ar in (II), (III) and (IV) represents a substituted or unsubstituted aromatic moiety. The aliphatic hydrocarbon group in (I) specifically constitutes $-C_nH_{2n}-$ (n is an integer of 2 to 8) and a hydrogen atom may be substituted.

Examples of type (I) polyols include ethylene glycol, 1,3-propanediol, 1,4-butanediol, 1,5-pentanediol, 1,6-hexanediol, 1,7-heptanediol, 1,8-octanediol, propyleneglycol, 2,3-dihydroxybutane, 1,2-dihydroxybutane, 1,3-dihydroxybutane, 2,2-dimethyl-1,3-propanediol, 2,4-pentanediol, 2,5-hexanediol, 3-methyl-1,5-pentanediol, 1,4-cyclohexanedimethanol, dihydroxycyclohexane, diethyleneglycol, 1,2,6-trihydroxyhexane, phenylethyleneglycol, 1,1,1-trimethylolpropane, hexanetriol, pentaerythritol and glycerin.

Examples of type (II) polyols include 1,4-di(2-hydroxyethoxy)benzene, resorcinol dihydroxyethylether and other such condensed products of polyhydric aromatic alcohols and alkyleneoxides.

Examples of type (III) polyols include p-xylyleneglycol, m-xylyleneglycol and α,α′-dihydroxy-p-diisopropylbenzene.

Examples of type (IV) polyols include 4,4′-dihydroxy-diphenylmethane, 2-(p,p′-dihydroxydiphenylmethyl)benzylalcohol, ethyleneoxide adducts in bisphenol A and propylene oxide adducts in bisphenol A. The polyols should preferably be used in the proportion of from 0.02 to 2 moles of hydroxyl group of the polyol to 1 mole of isocyanate group.

Water-soluble polymers may be used in the formation of microcapsules of the present invention. An anionic polymer, nonionic polymer or amphoteric polymer may be used as the water-soluble polymer. These anionic polymers may be natural or synthetic products and, for example, those having $-COO^-$, $-SO_3^-$ and like anionic groups. Anionic natural polymers include gum arabic, alginic acid and the like. Semi-synthetic products include carboxymethylcellulose, phthalized gelatin, sulfated starch, sulfated cellulose, lignin sulphonate and the like.

Synthetic products include anhydrous maleic acid-based (including hydrolized substances) copolymers, acrylic acid-based (including methacrylic acid-based) polymers and copolymers, vinylbenzenesulfonic acid-based polymers and copolymers, carboxy-modified polyvinyl alcohol and the like.

Nonionic polymers include polyvinyl alcohol, hydroxyethylcellulose, methylcellulose and the like.

Amphoteric polymers include gelatin and the like.

These water-soluble polymers are used in aqueous solutions of 0.01 to 10 wt%. The particle size of the microcapsules is adjusted to an equivalent diameter of 20 µm or less. In general, the printed image quality readily deteriorates if the size exceeds 20 µm.

In particular, 8 µm or less is preferred when the heat is provided by a thermal head from the coated-layer side in order to avoid pressure fogging.

The term "particle size" refers to a volume average size of a microcapsule suspension measured by light-scattering method.

It is possible to select any one of the diazo compounds or the coupling components, which are the main components used in the present invention, or the basic substances, which are used as required, as the core material of the microcapsule. Alternatively two or three of these components can be incorporated as the core material. When incorporating two of these components as the core material of the microcapsule, they each may be in the same microcapsule or in separate microcapsules. Three components may be incorporated as the core material of the microcapsules in various combinations. However, all three components cannot be included in the same microcapsule simultaneously. Components which are not contained in the core material of the microcapsule are in the heat-sensitive layers outside the microcapsule. In the present invention, it is preferred to encapsulate the diazo compounds.

The microcapsule can be produced from an emulsion containing 0.2 wt% or more of the component(s) to be encapsulated.

Regardless of the relative positions of the diazo compounds, coupling components and the basic substances within the microcapsule or outside the microcapsule and within a heat sensitive layer, the coupling components are preferably used in a proportion of 0.1 to 10 parts by weight and the basic substances are used in a proportion of 0.1 to 20 parts by weight, per part by weight of the diazo compound, respectively. Furthermore, the diazo compound is preferably coated in an amount of from 0.05 to 5.0 g/m$^2$ of recording material.

When the diazo compounds, coupling components and basic substances for use in the present invention are not microencapsulated, they may be used as a solid dispersion together with a water-soluble polymer prepared using a sand mill or the like. Preferred water-soluble polymers include the water-soluble polymers used for producing the microcapsules. The concentration of the water-soluble polymers is from 2 to 30 wt% of the solid dispersion solution and the diazo compounds, coupling components and basic substances are each introduced so that they occupy 5 to 40 wt% of the water-soluble polymer solution.

The size of the dispersed particles is preferably 10 µm or less.

The following compounds are preferably included in the heat-sensitive layer of the heat-sensitive recording material of the present invention in order to further improve the thermal color forming properties:

Ethers such as 2-benzyloxynaphthalene, 1-p-biphenyloxy-2-phenylethane, 2-benzoyloxy-naphthalene, 2-phenoxy-acety-loxy-naphthalene, 2-p-chlorobenzy-loxy naphthalene, 1-cydroxy-2-phenoxy-carbony-1naphthalene, 1,4-bisphenoxybutane, 1,2-bis-m-tolyloxyethane, 1-phenoxy-2-p-ethylphenoxy-ethane, 1,2-diphenoxyethane, 1-phenoxy-2-p-chlorophenoxy-ethane, bis(phenoxyethyl)oxalate, 1-phenoxy-2-p-methoxy-phenoxy-ethane, β-chloroethoxy-naphthalene, 1-phenoxy-2-p-tolyloxy-ethane, bis(phenoxy-ethyl)carbonate, biphenyl-β-methoxy-ethylether, p-biphenyl-β-cyclohexy-1oxyethy-1ether, β- cyanoethoxy-naphthalene, β-chloroethoxy-p-biphenyl, 2-phenoxy-pheny-1oxycarbonyl-phenol, 2-p-bipheny-1oxycarbony-1phenol, 2-β-naphthy-1oxy-carbony-1phenol, ethers such as bis(2-p-methoxy-phenoxyethyl)ether, bis(2-p-ethoxy-phenoxy-ethyl)ether, bis(2-p-methoxy-phenoxy-ethoxy)methylether, and 1,2-bis-4-methoxy-thiophenoxy-ethane; phenols such as butylphenol, p-t-octylphenol, p-α-cumylphenol, p-t-pentylphenol, 2,5-dimethylphenol, 2,4,5-trimethylphenyl, 3-methyl-4-isopropylphenol, p-benzylphenol, o-cyclohexylphenol, p-(diphenylmethyl)phenol, p-(α,α-diphenylethyl)phenol, o-phenylphenol, ethyl p-hydroxybenzoic acid, butyl p-hydroxybenzoic acid, benzyl p-hydroxybenzoic acid, p-methoxyphenol, p-butoxyphenol, p-heptyloxyphenol, p-benzyloxyphenol, 3-hydroxyphthalate, dimethyl vanilin, 2,5-diethylphenol, 1,1-bis(4-hydroxyphenyl)dodecane, 1,1-bis(4-hydroxyphenyl)-2-ethyl-hexane, 1,1-bis(4-hydroxyphenyl)-2-methyl-pentane, 2,2-bis(4-hydroxyphenyl)-heptane-vanilin, 2-t-butyl-4-methoxyphenol, 2,6-dimethoxyphenol, 2,2′-dihydroxy-4-methoxybenzophenone, phenoxyethyl-β-resorcinate, orsellinic acid methylbenzyl ester, and methylhydroxycinnamate; sulfonamides such as ethylbenzene sulfonamide, toluene sulfonamide, methoxybenzene sulfonamide, ethyltoluene sulfonamide, chloroethoxybenzene sulfonamide, (iso) propylbenzene sulfonamide, ethoxytoluene sulfonamide, t-amylbenzene sulfonamide, diethylbenzene sulfonamide, allylbenzene sulfonamide, ethoxybenzene sulfonamide, and cyclohexylbenzene sulfonamide; and amide compounds such as benzamide, m-methoxybenzamide, methylbenzamide, ethylbenzamide, isopropylbenzamide, butylbenzamide, t-amylbenzamide, cyclohexylbenzamide, di-methylbenzamide, nicotinamide , picolinamide, naphthamide, phenylbenzamide, chlorobenzamide, o-chlorobenzamide, methoxychlorobenzamide, methoxytoluamide, ethoxybenzamide, butylbenzamide, dimethylnaphthamide, trimethylbenzamide, dimethylchlorobenzamide, dimethoxychlorobenzamide, dimethoxybenzamide, diethoxybenzamide, chlorophenoxyacetoamide, pivaloylamide, 2-ethylhexanamide, p-acetoxybenzamide, diethylaminobenzamide, phthalamide, methoxycarbonylbenzamide, methoxynaphthamide, benzylbenzamide, chloroethylbenzamide, chloroethoxybenzamide, cyanobenzamide, benzyloxybenzamide and the like, and more preferably, o-toluamide, o-chlorobenzamide, p-ethylbenzamide, p-isopropylbenzamide, p-phenylbenzamide, α-toluamide, 2,4-dichlorobenzamide, 2,4-dimethylbenzamide, o-, m or p-methoxybenzamide, o-, m- or p-ethoxybenzamide, 2,4-diethoxybenzamide, 4-ethoxy-2-hydroxybenzamide, acetoxybenzamide and o-, m-or p-butoxybenzamide.

These compounds can be contained in the microcapsule together with the core material of the microcapsule or they can be used outside the microcapsule by addition to the coating liquid of heat-sensitive recording materials although it is preferable that they are contained in the microcapsule. In either case, the amount used is 0.01 to 10 parts by weight and preferably 0.1 to 5 parts by weight per part by weight of coupling component. The amount may be suitably selected to adjust the desired color density. Free-radical producing agents (compounds which produce free radicals on irradiation by light) as used, for example, in photopolymerizable compositions, may be added to the heat - sensitive recording materials of the present invention in order to reduce yellowing in the background part after photofixing. Free-radical producing agents for use in the present invention include aromatic ketones (for example, benzophenone, 4,4′-bis (dimethylamino) benzophenone, 4, 4′-bis(diethylamino)benzophenone, 4-methoxy-4′-(dimethylamino)benzophenone, 4,4′-dimethoxybenzophenone, 4-dimethylaminobenzophenone, 4-methoxy-3,3′-dimethylbenzophenone, 4-dimethylaminoacetophenone), cyclic aromatic ketones (for example, fluoren, anthrone, xanthone, thioxanthone, 2-chlorothioxanthone, 2,4-dimethylthio xanthone, 2,4-diethylthioxanthone, acridone, N-ethylacridone, benzanthrone), quinones (for example, benzoquinone, 2,3,5-trimethyl-6-bromobenzoquinone, 2,6-di-ndecyl-benzoquinone, 1,4-naphthoquinone, 2-isopropoxy1,4-naphthoquinone, 1,2-naphthoquinone, anthraquinone, 2-chloro-anthraquinone, 2-methylanthraquinone, 2-tert-butylanthraquinone, phenanthraquinone), benzoin, benzoin ethers (for example, benzoin methyl ether, benzoin ethyl ether, 2,2-dimethoxy-2-phenylacetophenone, α-methylolbenzoinmethylether), aromatic polycyclic hydrocarbons (for example, naphthalene, anthracene, phenanthracene, pyrene), azo compounds (for example, azobisisobutyronitrile, α-azo-1-cyclohexanecarbonitrile, azobisvaleronitrile), organic disulfides (for example, thiuram disulfide) and acyloxime esters (for example, benzyl-(o-ethoxy carbonyl)-α-monooxime).

The addition amount is preferably 0.01 to 5 parts by weight of free-radical producing agent per part by weight of diazonium compound. More preferably the proportion added is in the range from 0.1 to 1 part by weight.

Yellowing of the background part after photofixing may also be reduced by encapsulatingthe free-radical producing agent together with the diazonium salt as the core material. The free-radical producing agent may be used outside the micocapsule together with the solid dispersion of the diazo compound.

Polymerizable compounds having an unsaturated ethylenic bond (referred to as "vinyl monomers" below) may also be used in order to reduce the yellowing of the background part after photofixing. Vinyl monomers are compounds having at least one unsaturated ethylenic bond (for example, vinyl and vinylidene groups) in their chemical structure and may comprise a mixture or copolymer of monomers or prepolymers; i.e., dimers, trimers and other such oligomers. Examples include unsaturated carboxylic acid and salts thereof, esters of unsaturated carboxylic acid and aliphatic polyvalent alcohol compounds, and amides of unsaturated carboxylic acid and aliphatic polyfunctional amine compounds.

The vinyl monomers are used in a proportion of from 0.2 to 20 parts by weight per 1 part by weight of diazo compound. Preferably they are in a proportion of from 1 to 10 parts by weight.

The vinyl monomers can be contained in the core material of the microcapsule together with the diazo compounds. Part or all of the organic solvent thus used as the solvent (or dispersant) for the core material can be replaced with a vinyl monomer such that there is no need for an additional amount of monomer which would harden the core material.

When the diazo compounds are included as the core material within the heat-sensitive recording materials of the present invention, fogging may be prevented by including a coupling reaction deactivating agent outside of the microcapsule. The coupling reaction deactivating agent reacts with the diazo compounds present in the aqueous phase and with diazo compounds which are incompletely blocked by the capsule wall to stop the color forming reaction.

Substances which reduce the coloring of a solution wherein diazo compounds are dissolved may serve as the coupling reaction deactivating agent. These agents may be selected, by adding various test compounds to a solution of diazo compounds.

Specifically, hydroquinone, sodium bisulfite, potassium nitrite, hypophosphorous acid, stannous chloride and formalin can be used as coupling reaction deactivating agents in addition to the substances disclosed on pages 105 to 306 of The Aromatic Diazo Compounds and their Technical Applications by K.H. Saunders (London), published in 1949.

A coupling reaction deactivating agent is preferably a substance which contributes little or no side reactions and is transparent. More preferably, it is water-soluble.

A coupling reaction deactivating agent in the present invention is used in an amount such that it does not hinder the thermal color forming reaction of the diazo compounds and, normally, it is used in the range of from 0.01 mole to 2 moles per 1 mole of diazo compound. More preferably, it is used in the range of from 0.02 mole to 1 mole.

A coupling reaction deactivating agent, when used, is first dissolved in a solvent and then added to a dispersion of the microcapsules containing the diazo compound or to a dispersion of the coupling agent or the basic substance or to a mixture thereof. Preferably, the deactivating agent is added as an aqueous solution.

Pigments (for example, silica, barium sulfate, titanium oxide, aluminium hydroxide, zinc oxide, calcium carbonate), and fine powders (for example, styrene beads, ureamelamine resin) may be used in order to prevent the heat-sensitive recording material of the present invention from sticking to the thermal head and to improve writing properties.

Similarly, metallic soaps may also be used in order to prevent sticking in an amount of from 0.2 to 7 $g/m^2$ of

recording material.

Heat-fusible substances may also be used in the heat-sensitive recording material of the present invention in order to improve the heat recording density. Heat-fusible substances are solid at normal temperatures, have a melting point of 50 to 150°C, fuse upon heating with a thermal head and which dissolve diazo compounds, coupling components or basic substances. The heat-fusible substances are distributed over a particle size of 0.1 to 10 μm and are used with a solid fraction amount of from 0.2 to 7 $g/m^2$. Specific examples of the heat-fusible substances are aliphatic acid amides, N-substituted aliphatic acid amides, ketone compounds, urea compounds and esters.

The heat-sensitive recording layers can be coated onto a support by using a suitable binder.

Various emulsions of polyvinyl alcohol, methylcellulose, carboxymethylcellulose, hydroxypropylcellulose, gum arabic, gelatin, polyvinylpyrrolidone, casein, styrene-butadiene latex, acrylonitrile-butadiene latex, polyvinyl acetate, polyacrylate esters, ethylenevinyl acetate copolymers can be used as a binder material. The binder is used in a solid fraction amount of from 0.5 to 5 $g/m^2$.

Apart from the above materials, citric acid, tartaric acid, oxalic acid, boric acid, phosphoric acid and pyrophosphoric acid may be added as acid stabilizers in the present invention.

In order to fabricate the heat-sensitive recording materials of the present invention, a coating liquid containing the diazo compound, coupling components, basic substances and other additives is first produced. A heat sensitive layer with a solid fraction of from, 2.5 to 25 $g/m^2$ is then provided on a support of, for example, paper or synthetic resin by applying the coating liquid by bar coating, blade coating, air knife coating, gravure coating, roll coating, spray coating, dip coating or the like followed by drying.

Laminated layer type coating may also be employed in which a precoating layer with a solid fraction of from 2 to 10 $g/m^2$ is first formed and dried on a support followed by application of a second coated layer having a solid fraction of from 1 to 15 $g/m^2$. The precoat contains, for example, a coupling component, a basic substance and other additives. The second layer contains, for example, a diazo compound and other additives. The components of both coating liquids may be added to the microcapsule as the core material, as a solid dispersion, or by mixing after dissolving in aqueous solution. The order of the laminated layers can be reversed. The coating liquids can be applied sequentially or simultaneously. Laminated layer-type heat-sensitive recording materials provide long-term fresh storage.

Furthermore, it is also possible to coat the heat sensitive layer onto a support having thereon an intermediate layer as disclosed, for example, in JP-A-61-54980.

The use of a heat-extruded neutral paper with a pH of 6 to 9 which has been sized with a neutral sizing agent (for example, alkylketene dimers) as the support, as described in JP-A-55-14281 improves long term storage properties.

Furthermore, papers with a Beck smoothness of 90 seconds or more and of

$$\frac{\text{Stockigt sizing degree}}{(\text{meter weight})^2} \geq 3 \times 10^{-3}$$

as disclosed in JP-A-57-116687 are beneficial in preventing the permeation of the coating liquid into the paper and for improving the contact between the thermal recording head and the heat-sensitive recording layer.

Furthermore, paper with an optical surface roughness of 8 μm or less and a thickness of 40 to 75 μm, as disclosed in JP-A-58-136492, paper with a density of 0.9 $g/m^3$ or less and with an optical contact interval of 15% or more as disclosed in JP-A-58-69091, paper manufactured from beat-treated pulp which prevents the penetration of coating solutions at 400 cc or more of Canadian standard freeness (JIS P8121) as disclosed in JP-A-58-69097, the substances with improved color density and resolving power which use the glossy surface of raw paper manufactured using a Yankee machine as their coated surface as disclosed in JP-A-58-65695, and paper with improved coatability in which the raw paper has undergone coronal discharge treatment as disclosed in JP-A-59-35985 and the like can be used in the present invention to give desirable results. Apart from these, it is possible to use smooth supports composed of synthetic polymers such as polyethyleneterephthalate and synthetic papers, coated papers and the like which are commonly used in the field of heat-sensitive recording materials.

The heat-sensitive recording materials of the present invention can be used as printer papers for facsimile and electronic computers which require highspeed recording and, moreover, can be fixed by decomposing unreacted diazo compounds by exposure after heat printing. Apart from this, they can also be used as thermodeveloping-type reprographic papers.

## EXAMPLES

The present invention is not limited to the following examples , wherein "parts" denotes "parts by weight".

EXAMPLE 1

3.45 parts of the diazo compounds shown below and 18 parts of a xylylenediisocyanate/trimethylolpropane (3:1) adduct were added and dissolved in a mixed solvent of 24 parts of tricresyl phosphate and 5 parts of ethyl acetate. This diazo compound solution was mixed with an aqueous solution in which 5.2 parts of polyvinyl alcohol had been dissolved in 58 parts of water, emulsified and dispersed at 20° C. An emulsion with an average particle size of 2.5 µm was thus obtained. 100 parts of water were added to the emulsion and this mixture was then heated to 60° C with stirring. Two hours later, a capsule liquid containing the diazo compound as its core material was obtained.

(diazo compound)

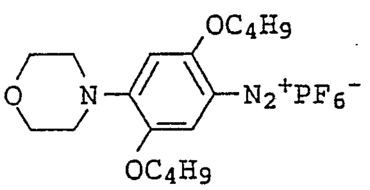

Next, 6 parts of 2-hydroxy-3-naphthoic acid anilide, 6 parts of triphenyl guanadine and 25 parts of parabenzyloxyphenol were added to 100 parts of 5% polyvinyl alcohol and were dispersed for about 24 hours in a sand mill. A dispersion with an average particle size of 3 µm was obtained.

Sixty parts of the dispersion of triphenyl guanidine, parabenzyloxyphenol and the coupling components were added to 50 parts of the diazo compound capsule liquid to constitute the coating liquid. This coating liquid was applied onto a smooth wood-free paper (50 g/m$^2$) using a coating bar such that it had a dry weight of 10 g/m$^2$ to produce a heat-sensitive recording paper.

5 parts of solution B were mixed with 100 parts of solution A as defined below and the mixture was coated onto the above recording paper in a dry weight of 0.1 g/m$^2$ (dry weight of sodium alginate 0.03 g/m$^2$) to form an overcoat protective layer.

Solution A: 0.8 part of sodium alginate (degree of polymerization is ca. 130) dissolved in 100 parts of water.

Solution B: 40 parts of kaolin dispersed in an aqueous solution in which 0.6 part of sodium hexametaphosphate had been dispersed in 60 parts of water.

EXAMPLE 2

A heat-sensitive recording paper was obtained in the same manner as in Example 1 except that the coated amount of the coating solution for the overcoat layer had a dry weight of 0.3 g/m$^2$ (dry weight of sodium alginate 0.1 g/m$^2$).

EXAMPLE 3

A heat-sensitive recording paper was obtained in the same manner as in Example 1 except that the coated amount of the coating solution for the overcoat layer had a dry weight of 0.5 g/m$^2$ (dry weight of sodium alginate 0.15 g/m$^2$).

EXAMPLE 4

A heat-sensitive recording paper was obtained in the same manner as in Example 1 except that the coated amount of the coating solution for the overcoat layer had a dry weight of 1.5 g/m$^2$ (dry weight of sodium alginate 0.4 g/m$^2$).

EXAMPLE 5

A heat-sensitive recording paper was obtained in the same manner as in Example 3 except that the Solution A as defined above was composed of 0.8 part of sodium alginate (degree of polymerization is ca. 70) dissolved in 100 parts of water.

## COMPARATIVE EXAMPLE 1

A heat-sensitive recording paper as in Example 1 without an overcoat layer was used as a comparative material.

## COMPARATIVE EXAMPLE 2

A heat-sensitive recording paper was obtained as in Example 1 except that the overcoat layer had a dry weight of 1.8 g/m$^2$ (dry weight of sodium alginate 0.5 g/m$^2$).

## COMPARATIVE EXAMPLE 3

A heat-sensitive recording paper was obtained as in Example 1 except that the overcoat layer had a dry weight of 3 g/m$^2$ (dry weight of sodium alginate 0.9 g/m$^2$).

The heat-sensitive recording papers obtained as above were subjected to color formation by heating for 5 seconds at 120° C. The recorded image was stored in an air thermostatic chamber at 60° C in a dark location for 16 hours (i.e., an enforced deterioration test), and then the degree of reduction in the density of the recorded image was assessed after storage. The enforced deterioration test was performed in order to investigate the reduction in the optical density of the color forming part resulting from long-term storage after thermal recording. The results are shown in Table 1.

Additionally, a facsimile machine manufactured by NEC Corporation and sold under the trade name Nefax-24, was used to print on these heat-sensitive recording paper and the image density of the color forming part was measured. The results are shown in Table 2.

The image density was measured by a Macbeth reflection-type optical density apparatus.

As a result, it was found that materials without an overcoat layer exhibited a larger density reduction in the recorded image and also that materials provided with an overcoat layer containing 0.5 g/m$^2$ or more sodium alginate had a large color density reduction.

TABLE 1

| Heat-sensitive recording material | Image density | Reduction in recorded image density after an enforced deterioration test |
|---|---|---|
| Example 1 | 1.15 | Δ |
| Example 2 | 1.15 | ○ |
| Example 3 | 1.15 | ○ |
| Example 4 | 1.15 | ○ |
| Example 5 | 1.15 | ○ |
| Comparative Example 1 | 1.15 | × |
| " 2 | 1.13 | ○ |
| " 3 | 1.10 | ○ |

Reduction in recorded image density after an enforced deterioration test

○ The density reduction after the test in terms of the initial density was 5%.

Δ The density reduction after the test in terms of the initial density was 6% or above and 10% or less.

× The density reduction after the test in terms of the initial density was 11% or more.

TABLE 2

| Heat-sensitive recording material | Image density of the color forming portion |
|---|---|
| Example 1 | 1.10 |
| Example 2 | 1.10 |
| Example 3 | 1.10 |
| Example 4 | 1.05 |
| Example 5 | 1.10 |
| Comparative Example 2 | 1.00 |
| Comparative Example 3 | 0.90 |

**Claims**

1. A heat-sensitive recording material comprising a support having thereon a recording layer containing a diazo compound and a coupling component at least one of which is contained in microcapsules within the layer, and on said recording layer there is an overcoat layer comprising an alginate in an amount of from 0.03 $g/m^2$ to 0.4 $g/m^2$.
2. A recording material as claimed in Claim 1, wherein the alginate is an alkali metal salt, ammonium salt or organic amine salt of alginic acid.
3. A recording material as claimed in Claim 2, wherein the alginate is sodium alginate, potassium alginate, ammonium salt of alginic acid or the triethanolamine salt of alginic acid.
4. A recording material as claimed in Claim 3, wherein the alginate is sodium alginate having a degree of polymerization of 60 to 130.
5. A recording material as claimed in any preceding claim, wherein said diazo compound is microencapsulated.
6. A recording material as claimed in any preceding claim, wherein said recording layer further comprises a basic substance.
7. A recording material as claimed in any preceding claim, wherein the overcoat layer also contains a pigment.